(19) Europäisches Patentamt
European Patent Office
Office européen des brevets

(11) **EP 3 072 017 B1**

(12) **EUROPÄISCHE PATENTSCHRIFT**

(45) Veröffentlichungstag und Bekanntmachung des Hinweises auf die Patenterteilung:
**19.06.2019 Patentblatt 2019/25**

(21) Anmeldenummer: **14703042.3**

(22) Anmeldetag: **22.01.2014**

(51) Int Cl.:
*G05B 19/042* *(2006.01)*    *G01R 19/25* *(2006.01)*

(86) Internationale Anmeldenummer:
**PCT/EP2014/051196**

(87) Internationale Veröffentlichungsnummer:
**WO 2015/110150 (30.07.2015 Gazette 2015/30)**

(54) **DIGITALER MESSEINGANG FÜR EIN ELEKTRISCHES AUTOMATISIERUNGSGERÄT, ELEKTRISCHES AUTOMATISIERUNGSGERÄT MIT EINEM DIGITALEN MESSEINGANG UND VERFAHREN ZUM VERARBEITEN VON DIGITALEN EINGANGS-MESSWERTEN**

DIGITAL MEASUREMENT INPUT FOR AN ELECTRIC AUTOMATION DEVICE, ELECTRIC AUTOMATION DEVICE COMPRISING A DIGITAL MEASUREMENT INPUT, AND METHOD FOR PROCESSING DIGITAL INPUT MEASUREMENT VALUES

ENTRÉE DE MESURE NUMÉRIQUE POUR APPAREIL D'AUTOMATISME ÉLECTRIQUE, APPAREIL D'AUTOMATISME ÉLECTRIQUE DOTÉ D'UNE ENTRÉE DE MESURE NUMÉRIQUE ET PROCÉDÉ DE TRAITEMENT DE VALEURS DE MESURE D'ENTRÉE NUMÉRIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.09.2016 Patentblatt 2016/39**

(73) Patentinhaber: **Siemens Aktiengesellschaft 80333 München (DE)**

(72) Erfinder: **JURISCH, Andreas 16727 Schwante (DE)**

(56) Entgegenhaltungen:
**DE-A1- 19 860 720    US-A- 6 137 349**

**Beschreibung**

Die Erfindung betrifft einen digitalen Messeingang für ein elektrisches Automatisierungsgerät, mit einer Empfangseinrichtung, die zum Empfang digitaler Eingangs-Messwerte eingerichtet ist, die durch Abtastung eines analogen Messsignals mit einer ersten Abtastrate erzeugt worden sind, und einer Signalumsetzeinrichtung, die dazu ausgebildet ist, aus den digitalen Eingangs-Messwerten digitale Ausgangs-Messwerte zu bilden und bereitzustellen, wobei die digitalen Ausgangs-Messwerte hinsichtlich ihrer Abtastrate und/oder ihres jeweiligen Abtastzeitpunktes an eine vorgegebene Abtastrate und/oder vorgegebene Abtastzeitpunkte angepasst sind. Die Erfindung betrifft außerdem ein Automatisierungsgerät mit einem solchen digitalen Messeingang und ein Verfahren zum Verarbeiten von digitalen Eingangs-Messwerten.

Elektrische Automatisierungsgeräte werden beispielsweise zur Steuerung, Überwachung und zum Schutz elektrischer Energieversorgungsnetze eingesetzt. Herkömmlicherweise sind die Automatisierungsgeräte dazu möglichst in der Nähe einer Messstelle angeordnet und nehmen mittels an der Messstelle vorgesehener Sensoren, z.B. Strom- und/oder Spannungswandler, analoge Messsignale auf, die im Automatisierungsgerät nachfolgend weiterverarbeitet werden. Ein wesentlicher Schritt bei der Weiterverarbeitung ist die Umsetzung des analogen Messsignals in digitale Abtastwerte, die den Verlauf des Analogsignals beschreiben. Unter Verwendung dieser digitalen Abtastwerte können in dem Automatisierungsgerät daraufhin Steuer-, Überwachungs- und Schutzfunktionen durchgeführt werden. Sofern das Automatisierungsgerät nicht in der Nähe aller Sensoren angeordnet werden kann, werden die analogen Messsignale über entsprechende Messleitungen an das Automatisierungsgerät herangeführt.

Seit jüngerer Zeit bestehen Bestrebungen, die analogen Messsignale in Sensornähe mit sogenannten "Merging Units" in digitale Messsignale umzusetzen. Grund dafür sind unter anderem neue Sensor- bzw. Wandlertypen (z.B. Rogowskiwandler, optische Wandler), deren Signale sich auf analogem Wege nicht mehr über die bisher üblichen Entfernungen verteilen lassen. Hierbei weist eine solche Merging Unit einen oder mehrere analoge Messeingänge auf, deren analoge Eingangssignale mit einem Analog-Digital-Umsetzer der Merging Unit nachfolgend abgetastet und so in digitale Messwerte umgesetzt werden. Die digitalen Messwerte werden an einem Ausgang der Merging Unit üblicherweise in Form von Datentelegrammen ausgegeben und über einen Kommunikationsnetz oder einen Kommunikationsbus an ein oder mehrere übergeordnete Automatisierungsgeräte übertragen. Ein Beispiel einer solchen Merging Unit ist z.B. der Europäischen Patentanmeldung EP 2503668 A1 zu entnehmen.

Bei der Verwendung von über Merging Units erzeugten digitalen Messwerten entstehen jedoch neuartige Problemstellungen, die im Wesentlichen mit der zur Bildung der digitalen Messwerte in der Merging Unit verwendeten Abtastrate und/oder den Abtastzeitpunkten der jeweiligen digitalen Messwerte zusammenhängen. So kann es beispielsweise vorkommen, dass das Automatisierungsgerät intern digitale Messwerte mit einer Abtastrate benötigt, die von der in der Merging Unit verwendeten Abtastrate abweicht. Darüber hinaus besteht bei Verwendung mehrerer unterschiedlicher Messsignale die Anforderung, dass diese bezüglich ihrer Abtastrate und ihrer Abtastzeitpunkte miteinander vergleichbar sein müssen. Letzteres tritt beispielsweise bei Automatisierungsgeräten auf, die mehrere digitale Signaleingänge aufweisen, die digitale Messwerte von unterschiedlichen Merging Units erhalten. Zwar werden manche Merging Units üblicherweise über ein externes Zeitsynchronisationssignal (z.B. 1PPS-Zeitimpulse des GPS-Signals) untereinander zeitsynchronisiert und besitzen dadurch die Möglichkeit, ihre Abtastraten und Abtastzeitpunkte aufeinander abzustimmen. Diese Synchronisierung ist jedoch sehr aufwendig und kann beim Ausfall des externen Zeitsynchronisationssignals nur bedingt aufrecht erhalten werden.

Darüber hinaus können auch die Messwandler selbst bereits digitale Messwerte an ihren Ausgängen abgeben, die Problemstellung hierbei ist jedoch dieselbe wie bei über Merging Units erzeugten digitalen Messwerten.

Ein digitaler Messeingang der eingangs genannten Art sowie ein Verfahren zum Synchronisieren mehrerer digitaler Eingangssignale in einem Automatisierungsgerät sind beispielsweise aus der deutschen Offenlegungsschrift DE 198 60 720 A1 bekannt. Gemäß dem hieraus bekannten Verfahren werden aufseiten der Merging Unit die digitalen Abtastwerte mehrerer Messsignale mit einem ersten Filter encodiert und daraufhin an das Automatisierungsgerät übertragen. Dieses führt nach dem Empfang der encodierten digitalen Messwerte zunächst eine Nachabtastung mit einem Abtasttakt durch, der mindestens doppelt so schnell wie die schnellste Abtastrate der Messsignale ist.

Dabei werden nicht im Verlauf der encodierten digitalen Messwerte vorhandene Werte mit Nullwerten aufgefüllt. Die auf diese Art nachabgetasteten encodierten digitalen Messwerte werden einem Interpolationsfilter zugeführt, der eine zum Encoder-Filter inverse Filtercharakteristik aufweist. Hierdurch kann erreicht werden, dass alle digitalen Eingangssignale nach der Verarbeitung einen gemeinsamen Abtasttakt und gemeinsame Abtastzeitpunkte aufweisen.

Die Implementierung dieses bekannten Verfahrens stellt jedoch vergleichsweise hohe Anforderungen an die Rechenkapazität des Automatisierungsgerätes, beispielsweise entstehen durch die Nachabtastung mit einem relativ hohen Abtasttakt und das Auffüllen mit Nullwerten an der halben Frequenz der verwendeten Abtastrate gespiegelte Frequenzanteile der digitalen Messsignale, die erst durch aufwendige Filterung wieder entfernt werden müssen. Außerdem sehen aktuelle Normen, z.B. die Norm IEC 61850-9-2, keine Signalencodierung aufseiten einer Merging Unit vor, so dass die erzeugten digitalen Messsignale nicht ohne Weiteres mit Automatisierungsgeräten unterschiedlicher Hersteller verarbeitet werden können.

Ausgehend von einem digitalen Messeingang der eingangs genannten Art liegt der Erfindung somit die Aufgabe zugrunde, einen digitalen Messeingang anzugeben, mit dem bei effizienter Ausnutzung von Rechenkapazitäten eines Automatisierungsgerätes eine Verarbeitung von interoperabel verwendbare digitalen Eingangs-Messwerten erfolgen kann. Der Erfindung liegt zudem auch die Aufgabe zugrunde, ein entsprechendes Automatisierungsgerät mit einem digitalen Messeingang sowie ein Verfahren zum Verarbeiten von digitalen Eingangs-Messwerten anzugeben.

Hinsichtlich des digitalen Messeingangs wird zur Lösung dieser Aufgabe erfindungsgemäß vorgeschlagen, einen Messeingang der eingangs genannten Art derart fortzubilden, dass die Signalumsetzeinrichtung eingangsseitig einen digitalen Encoder-Filter und ausgangsseitig einen digitalen Decoder-Filter aufweist, zwischen denen ein Interpolator vorgesehen ist, wobei der Encoder-Filter, der Interpolator und der Decoder-Filter derart aufeinander abgestimmt sind, dass durch sie die Anpassung der digitalen Eingangs-Messwerte hinsichtlich Abtastrate und/oder Abtastzeitpunkten bewirkt wird.

Durch die Ausbildung der Signalumsetzeinrichtung des digitalen Messeingangs ist es möglich, eine Anpassung der digitalen Eingangs-Messwerte hinsichtlich ihrer Abtastrate und/oder ihrer Abtastzeitpunkte ohne eine Signalencodierung in der Merging Unit durchzuführen, wodurch die interoperable Verwendbarkeit der digitalen Eingangs-Messwerte für Geräte unterschiedlicher Hersteller gewährleistet wird. Da in der Signalumsetzeinrichtung außerdem keine aufwendige Nachabtastung mit Einfügen von Nullwerten durchgeführt wird, kann die zur Anpassung benötigte Rechenleistung und die damit verbundene Rechenzeit minimiert werden. Die beiden Filter und der Interpolator der Signalumsetzeinrichtung wirken hierbei derart zusammen, dass eine gewünschte Änderung der Abtastrate und/oder Verschiebung der Abtastzeitpunkte der ausgangsseitig bereitgestellten digitalen Ausgangs-Messwerte erreicht wird. Beispielsweise kann mit dem erfindungsgemäßen digitalen Messeingang eine Abtastratenänderung von 4 kHz auf 16 kHz stattfinden, indem die benötigten zusätzlichen Abtastwerte für die digitalen Ausgangs-Messwerte durch Interpolation aus dem Verlauf der eingangsseitig vorliegenden digitalen Eingangs-Messwerte ermittelt werden. Auch kann der Interpolator auf Grundlage der bekannten digitalen Eingangs-Messwerte mit hinreichender Genauigkeit für einen bestimmten zukünftigen Zeitraum den Verlauf digitaler Ausgangs-Messwerte abschätzen, so dass er quasi als Extrapolator eingesetzt wird und anhand eines vergangenen Verlaufs digitaler Eingangs-Messwerte zukünftige digitale Ausgangs-Messwerte abschätzt.

Gemäß einer vorteilhaften Ausführungsform des erfindungsgemäßen digitalen Messeingangs ist vorgesehen, dass der Interpolator zur Erzeugung von interpolierten digitalen Hilfsmesswerten unter Verwendung eines Signalmodells eingerichtet ist.

Hierdurch kann eine möglichst genaue Abschätzung der durch Interpolation zu ermittelnden Hilfsmesswerte und damit der digitalen Ausgangs-Messwerte erfolgen. Im einfachsten Fall kann für die Interpolation ein linearer Interpolator auf Basis zweier bekannter digitaler Eingangs-Messwerte eingesetzt werden.

Als besonders vorteilhaft wird es jedoch angesehen, wenn das Signalmodell eine quadratische Funktion beschreibt.

Bei Verwendung eines quadratischen Signalmodells der Form

$$y = a \cdot x^2 + b \cdot x + c$$

können die interpolierten Hilfsmesswerte und damit die digitalen Ausgangs-Messwerte y einerseits mit relativ guter Genauigkeit und andererseits mit vertretbarem Rechenaufwand und vertretbarer Zeitverzögerung ermittelt werden, da zur Bestimmung der Koeffizienten a, b und c des Interpolators lediglich die letzten drei digitalen Eingangs-Messwerte benötigt werden.

Eine weitere vorteilhafte Ausführungsform des erfindungsgemäßen digitalen Messeingangs sieht zudem vor, dass der Encoder-Filter und der Decoder-Filter individuelle Übertragungsfunktionen aufweisen, die derart aufeinander abstimmbar sind, dass ihre gemeinsame Übertragungsfunktion eine einstellbare Verschiebung des Phasengangs der Abfolge digitaler Eingangs-Messwerte zur Erzeugung einer gewünschten zeitlichen Verschiebung der digitalen Ausgangs-Messwerte im Vergleich zu den digitalen Eingangs-Messwerten bewirkt.

Bei dieser Ausführungsform kann durch die bloße Auswahl der Übertragungsfunktionen der beiden Filter der Signalumsetzeinrichtung eine gewünschte zeitliche Verschiebung des Verlaufs der digitalen Ausgangs-Messwerte bezüglich des Verlaufs der digitalen Eingangs-Messwerte erreicht werden. Dies wird durch Beeinflussung des Phasengangs der digitalen Eingangs-Messwerte erreicht. Bei entsprechender Abstimmung der Übertragungsfunktionen der einzelnen Filter lässt sich nämlich eine Summenübertragungsfunktion erzielen, die den gewünschten zeitlichen Verschiebungseffekt erreicht. Hierdurch kann auf vergleichsweise einfache Art und Weise, nämlich bereits durch die Definition der jeweiligen Filterkoeffizienten, eine zeitliche Verschiebung des Verlaufs der digitalen Ausgangs-Messwerte erreicht werden, beispielsweise um Anpassungen mehrerer zeitlich verschoben eingehender digitaler Messwertverläufe aufeinander vorzunehmen.

Konkret kann hinsichtlich der beiden Filter beispielsweise vorgesehen sein, dass der Encoder-Filter eine PD-Charakteristik (proportional-derivative) aufweist und der Decoder-Filter eine Tiefpasscharakteristik aufweist.

Insbesondere durch die Ausbildung des Decoder-Filters mit Tiefpasscharakteristik kann erreicht werden, dass - in den digitalen Eingangs-Messwerten bereits enthaltene oder durch die Interpolation entstehende - ungewollte hohe Frequenzanteile im Verlauf der digitalen Ausgangs-Messwerte ausreichend gedämpft werden, so dass sie auf eine nachfolgende Weiterverarbeitung der digitalen Ausgangs-Messwerte zu Steuer-, Überwachungs- und/oder Schutzzwecken keine störenden Einflüsse ausüben.

Gemäß einer weiteren vorteilhaften Ausführungsform des erfindungsgemäßen digitalen Messeingangs ist vorgesehen, dass der digitale Messeingang in Form eines Verarbeitungsbausteins mit hardwarebestimmter Programmierung, insbesondere eines ASICs oder eines FPGAs, ausgebildet ist.

Die Ausbildung des digitalen Messeingangs in Form eines Verarbeitungsbausteins mit hardwarebestimmter Programmierung bietet im Vergleich zu einem eine Gerätesoftware abarbeitenden Prozessorbaustein den Vorteil der höheren Verarbeitungsgeschwindigkeit, da etwaige durch die prozessorgestützte Abarbeitung der Gerätesoftware entstehende Verzögerungen ausgeschlossen werden können. Der Verarbeitungsbaustein kann somit hoch spezialisiert für die benötigte Verarbeitungsaufgabe ausgebildet werden.

In diesem Zusammenhang wird es zudem als vorteilhaft angesehen, wenn der Verarbeitungsbaustein ein Speicherregister aufweist, in dem Filterkoeffizienten des Encoder-Filters und/oder des Decoder-Filters veränderbar abgespeichert sind.

Hierdurch kann erreicht werden, dass die Übertragungsfunktionen der beiden Filter auch nachträglich entsprechend eines gewünschten Signalgangs, insbesondere eines gewünschten Phasengangs einer gemeinsamen Summenübertragungsfunktion, angepasst werden können.

Gemäß einer weiteren vorteilhaften Ausführungsform des erfindungsgemäßen digitalen Messeingangs ist zudem vorgesehen, dass die Empfangseinrichtung zum Empfang der digitalen Eingangs-Messwerte in Form von Datentelegrammen ausgebildet ist.

Dabei können die digitalen Eingangs-Messwerte von der Merging Unit an das Automatisierungsgerät beispielsweise als sogenannte "Sampled Measured Values" (SMV) gemäß dem bei der Kommunikation in Energieautomatisierungsanlagen mittlerweile gängigen Standard IEC 61850, speziell dem Normteil IEC 61850-9-2, übertragen werden. Durch die Verwendung einer international anerkannten Norm für die übertragen digitalen Eingangs-Messwerte wird die Interoperabilität nochmals gesteigert.

In diesem Zusammenhang wird es zudem als vorteilhaft angesehen, wenn die Empfangseinrichtung dazu eingerichtet ist, den die digitalen Eingangs-Messwerte enthaltenden Datentelegrammen eine Information über die erste Abtastrate zu entnehmen und diese an die Signalumsetzeinrichtung weiterzugeben.

Die Information über die Abtastrate, mit der die digitalen Eingangs-Messwerte aus dem analogen Messsignal erzeugt worden sind, wird vom Interpolator benötigt, um die empfangenen digitalen Eingangs-Messwerte zeitlich korrekt anordnen zu können. Die fragliche Information kann entweder direkt in den Datentelegrammen enthalten sein (beispielsweise kann die Information hierbei einmalig oder sporadisch oder dauernd übertagen werden), oder indirekt aus den digitalen Eingangs-Messwerten selbst entnommen werden. Beispielsweise können den digitalen Eingangs-Messwerten von der Merging Unit sogenannte Zeitstempel zugeordnet sein, die den Abtastzeitpunkt in der Merging Unit angeben und aus denen die Abtastrate berechnet werden kann. Alternativ können die digitalen Eingangs-Messwerte auch sogenannte Zählwerte bzw. "Counter Values" umfassen, die ihre zeitliche Abfolge folgend auf einen zeitlichen Synchronisationspuls (z.B. ein 1PPS-Signal) angeben. Aus dem höchsten Wert eines solchen Zählwertes kann ebenfalls auf die Abtastrate geschlossen werden (z.B. bedeutet ein höchster Wert von 3999 eine Abtastrate von 4 kHz, da der erste Wert üblicherweise den Zählwert 0 erhält).

Die oben genannte Aufgabe hinsichtlich der Automatisierungsgerätes wird zudem durch ein Automatisierungsgerät mit einem digitalen Messeingang nach einem der Ansprüche 1 bis 9 gelöst.

Hinsichtlich des erfindungsgemäßen Automatisierungsgerätes gilt alles bereits zu dem erfindungsgemäßen digitalen Messeingang Gesagte, insbesondere kann das erfindungsgemäße Automatisierungsgerät einen digitalen Messeingang gemäß jeder der diesbezüglich oben beschriebenen Ausführungsformen umfassen. Auch hinsichtlich der Vorteile des erfindungsgemäßen Automatisierungsgerätes wird auf die Vorteile des erfindungsgemäßen digitalen Messeingangs verwiesen.

Das Automatisierungsgerät kann neben dem digitalen Messeingang auch eigene lokale analoge Messeingänge besitzen. In diesem Fall wird es als vorteilhafte Ausgestaltung des erfindungsgemäßen elektrischen Automatisierungsgerätes angesehen, wenn das elektrische Automatisierungsgerät zumindest einen analogen Signaleingang aufweist, der zur Erfassung eines lokalen analogen Messsignals und zur Bildung lokaler digitaler Messwerte eingerichtet ist, und wenn die Signalumsetzeinrichtung des digitalen Messeingangs derart ausgebildet ist, zur Anpassung der digitalen Eingangs-Messwerte hinsichtlich Abtastrate und/oder Abtastzeitpunkten die Abtastrate und/oder die Abtastzeitpunkte der lokalen digitalen Messwerte als vorgegebene Abtastrate und/oder vorgegebene Abtastzeitpunkte zu verwenden.

Bei dieser Ausführungsform weist das Automatisierungsgerät neben einem digitalen Messeingang auch zumindest einen analogen Messeingang auf, erfasst über diesen lokal ein analoges Messsignal und tastet es mit einem eigenen Analog-Digital-Umsetzer unter Bildung lokaler digitaler Messwerte ab. Hierbei können einerseits Unterschiede zwischen der lokal verwendeten Abtastrate und der Abtastrate einer vorgelagerten Merging Unit bestehen. Andererseits wird sich üblicherweise auch die durch die lokale Abtastung des analogen Messsignals entstehende zeitliche Verzögerung von derjenigen zeitlichen Verzögerung, die bei der Abtastung in der Merging Unit und dem anschließenden Übertragen der dort gebildeten digitalen Eingangs-Messwerte an das Automatisierungsgerät entsteht, unterscheiden. Üblicherweise wird die lokale Verarbeitung im Automatisierungsgerät eine kürzere zeitliche Verzögerung hervorrufen. Daher wird bei einem solchen Automatisierungsgerät mit einer gemischten analogen und digitalen Messwerterfassung eine Anpassung des Verlaufes der digitalen Eingangs-Messwerte an den Verlauf der lokalen digitalen Messwerte erfolgen müssen, um die kürzest mögliche zeitliche Verzögerung zu erreichen. Dies kann beispielsweise durch entsprechende Ausbildung der Übertragungsfunktionen der beiden Filter ermöglicht werden, die den Phasengang der eingehenden digitalen Eingangs-Messwerte derart beeinflussen, dass quasi eine zeitliche Zurückdrehung stattfindet und die im Vergleich zu den lokalen digitalen Messwerten auftretende zusätzliche Verzögerung eliminiert wird. Zudem kann auch durch den Interpolator eine dieser zeitlichen Verzögerung entsprechende zeitliche Vorausberechnung der digitalen Ausgangs-Messwerte erfolgen, um die zusätzliche zeitliche Verzögerung auszugleichen.

Eine weitere vorteilhafte Ausführungsform des erfindungsgemäßen Automatisierungsgerätes sieht zudem vor, dass das Automatisierungsgerät zumindest einen weiteren digitalen Messeingang aufweist, der entsprechend dem digitalen Messeingang ausgebildet sind.

Durch diese Ausführungsform können auch mehrere digitale Messeingänge derart aufeinander oder auf einen etwaigen lokalen analogen Messeingang abgestimmt werden, dass die jeweiligen ausgangsseitig abgegebenen digitalen Ausgangs-Messwerte hinsichtlich ihrer Abtastrate und/oder ihrer Abtastzeitpunkte aufeinander abgestimmt sind, d.h., jeder Messkanal weist eine eigene zeitliche Übertragungscharakteristik auf, die dazu ausgebildet ist, bestehende Unterschiede zwischen den einzelnen Messkanälen auszugleichen.

Alternativ kann auch vorgesehen sein, dass der erste digitale Messeingang zum Empfang und zur Verarbeitung mehrerer Verläufe digitaler Eingangs-Messwerte ausgebildet ist.

Bei dieser Alternative werden die unterschiedlichen Verläufe digitaler Eingangs-Messwerte über einen Multiplexer der Signalanpassungseinrichtung zugeführt, die - analog wie oben zu dem digitalen Messeingang beschrieben - für jedes Signal individuell eine Anpassung hinsichtlich Abtastrate und/oder Abtastzeitpunkten vornimmt.

Die oben genannte Aufgabe wird hinsichtlich des Verfahrens durch ein Verfahren zum Verarbeiten von digitalen Eingangs-Messwerten, die durch Abtastung eines analogen Messsignals mit einer ersten Abtastrate erzeugt worden sind, gelöst, wobei bei dem Verfahren mit einer Empfangseinrichtung eines digitalen Messeingangs eines Automatisierungsgerätes die digitalen Eingangs-Messwerte empfangen werden und mit einer Signalumsetzeinrichtung des digitalen Messeingangs, aus den digitalen Eingangs-Messwerten digitale Ausgangs-Messwerte gebildet und bereitgestellt werden, wobei die digitalen Ausgangs-Messwerte hinsichtlich ihrer Abtastrate und/oder ihres jeweiligen Abtastzeitpunktes an eine vorgegebene Abtastrate und/oder vorgegebene Abtastzeitpunkte angepasst sind.

Erfindungsgemäß ist vorgesehen, dass die digitalen Eingangs-Messwerte mit einem digitalen Encoder-Filter der Signalumsetzeinrichtung unter Bildung von encodierten digitalen Eingangs-Messwerten gefiltert werden, die encodierten digitalen Eingangs-Messwerte mit einem Interpolator der Signalumsetzeinrichtung unter Bildung von digitalen Hilfsmesswerten interpoliert werden, und die digitalen Hilfsmesswerte mit einem digitalen Decoder-Filter der Signalumsetzeinrichtung unter Bildung der digitalen Ausgangs-Messwerte gefiltert werden, wobei der Encoder-Filter, der Interpolator und der Decoder-Filter derart aufeinander abgestimmt sind, dass sie die Anpassung der digitalen Eingangs-Messwerte hinsichtlich Abtastrate und/oder Abtastzeitpunkten bewirken.

Hinsichtlich des erfindungsgemäßen Verfahrens gilt darüber hinaus alles bereits zu dem erfindungsgemäßen digitalen Messeingang und zum erfindungsgemäßen Automatisierungsgerät Gesagte, so dass das erfindungsgemäße Verfahren auch zur Verarbeitung der digitalen Eingangs-Messwerte gemäß jeder der oben beschriebenen Ausführungsformen des erfindungsgemäßen digitalen Messeingangs und des erfindungsgemäßen Automatisierungsgerätes geeignet ist. Auch hinsichtlich der Vorteile des erfindungsgemäßen Verfahrens wird auf die Vorteile des erfindungsgemäßen digitalen Messeingangs und des erfindungsgemäßen Automatisierungsgerätes verwiesen.

Eine vorteilhafte Ausführungsform des erfindungsgemäßen Verfahren sieht zudem vor, dass eine aus einer Verknüpfung der individuellen Übertragungsfunktionen des Encoder-Filters und des Decoder-Filters resultierende gemeinsame Übertragungsfunktion eine einstellbare Verschiebung des Phasengangs der Abfolge der digitalen Eingangs-Messwerte zur Erzeugung einer gewünschten zeitlichen Verschiebung der digitalen Ausgangs-Messwerte im Vergleich zu den digitalen Eingangs-Messwerten bewirkt.

Bei dieser Ausführungsform kann durch die bloße Auswahl der Übertragungsfunktionen der beiden Filter der Signalumsetzeinrichtung eine gewünschte zeitliche Verschiebung des Verlaufs der digitalen Ausgangs-Messwerte bezüglich des Verlaufs der digitalen Eingangs-Messwerte erreicht werden.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen digitalen Messeingangs, des erfindungsgemäßen Automatisierungsgerätes und des erfindungsgemäßen Verfahrens in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen

Figur 1 eine schematische Darstellung einer Energieautomatisierungsanlage mit an ein elektrisches Automatisierungsgerät angeschlossenen Merging Units;

Figur 2 eine schematische Darstellung eines Ausführungsbeispiels eines digitalen Messeingangs mit einer Signalumsetzeinrichtung;

Figur 3 ein Diagramm mit Verläufen eines analogen Signals, einer Abfolge von mit einer Merging Unit erzeugten digitalen Eingangs-Messwerten und einer Abfolge von mit einem Automatisierungsgerät erfassten lokalen digitalen Messwerten;

Figur 4 ein Diagramm mit einem vergrößerten Ausschnitt aus dem Diagramm in Figur 3;

Figur 5 ein Diagramm zur Erläuterung der Vorgehensweise bei der Interpolation auf Basis der digitalen Eingangs-Messwerte; und

Figur 6 ein Diagramm mit verschiedenen Signalverläufen zur Erläuterung der Datenverarbeitung in einer Signalumsetzeinrichtung.

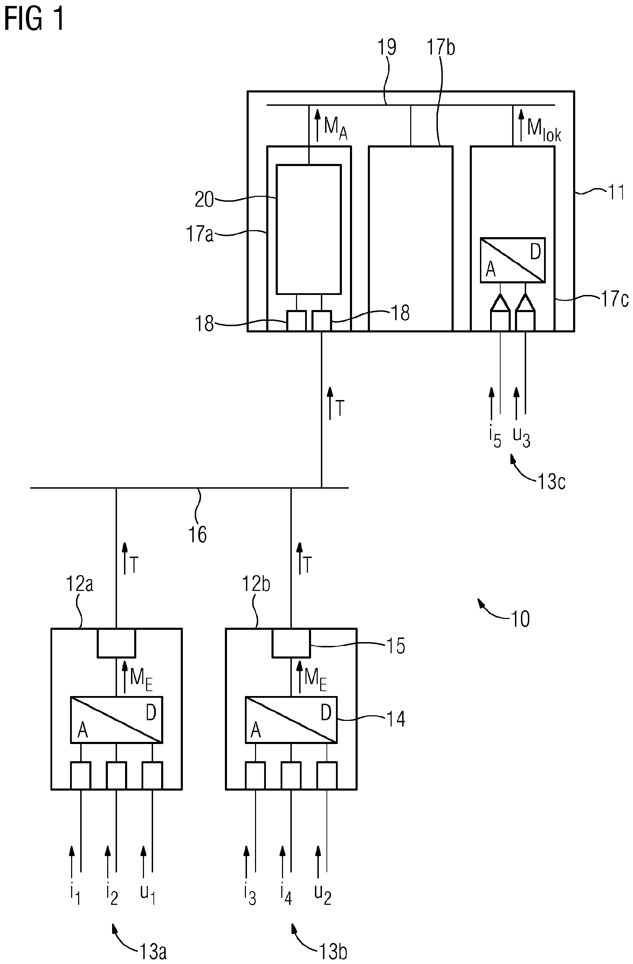

Figur 1 zeigt ein höchstschematisch dargestelltes Energieautomatisierungssystem 10 mit einem Automatisierungsgerät 11 und zwei Merging Units 12a-b. Das Automatisierungsgerät 11 kann beispielsweise ein Energieautomatisierungssystem sein, das zum Steuern, Überwachen und/oder Schützen eines in Figur 1 nicht gezeigten elektrischen Energieversorgungsnetzes dient. Das nachfolgend beschriebene Automatisierungsgerät 11 muss jedoch nicht zwingend in einem Energieautomatisierungssystem eingesetzt werden, sondern kann überall dort zur Automatisierung von Anlagen und Prozessen verwendet werden, wo extern gebildete digitale Messwerte verarbeitet werden müssen.

An Messstellen 13a-b des Energieversorgungsnetzes werden mittels geeigneter Wandler analoge Messsignale erfasst, die beispielsweise an den Messstellen 13a-b vorherrschende Ströme und/oder Spannungen angeben. Konkret werden beispielsweise an den Messstellen 13a und 13b analoge Stromsignale $i_1$, $i_2$, $i_3$ und $i_4$ sowie analoge Spannungssignale $u_1$ und $u_2$ erfasst und den Merging Units 12a-b zugeführt. Nachfolgend wird die Signalverarbeitung beispielhaft anhand der Merging Unit 12b beschrieben, die Beschreibung ist entsprechend auch auf die Merging Unit 12a anwendbar. Die Merging Unit 12b wandelt die empfangenen analogen Messsignale, hier konkret die Signale $i_3$, $i_4$, $u_2$ durch Abtastung mit einem Analog-Digital-Umsetzer 14 in digitale Eingangs-Messwerte $M_E$ um. Dabei kann der Analog-Digital-Umsetzer 14 zur Abtastung beispielsweise einen Abtasttakt von 4kHz verwenden. Der Abtasttakt kann durch ein externes Zeitsynchronisationssignal, z.B. einen 1PPS-Impuls (1PPS=1 Pulse per Second), synchronisiert oder freilaufend sein. Die Merging Unit 12b bildet mit den digitalen Eingangs-Messwerten $M_E$ Datentelegramme T und gibt diese ausgangsseitig über eine Datenschnittstelle 15 an einen auch als Prozessbus bezeichneten Datenkommunikationsbus 16 zur Übertragung von prozessbezogenen Messwerten, Ereignisdaten und Befehlen ab. Dabei können die die digitalen Eingangs-Messwerte $M_E$ enthaltenden Datentelegramme T beispielsweise als sogenannte "Sampled Measured Values" (SMV) gemäß dem Standard IEC 61850-9-2 ausgebildet sein und über einen Ethernet basierten Datenkommunikationsbus 16 übertragen werden.

Die Datentelegramme T werden dem Automatisierungsgerät 11 zugeführt. Dieses weist ein Prozessbusmodul 17a auf, mit dem die Telegramme T empfangen und daraus die darin enthaltenen digitalen Eingangs-Messwerte $M_E$ extrahiert werden. Das Prozessbusmodul 17a weist zum Empfang der Datentelegramme T mindestens eine physikalische Prozessbusschnittstelle, z.B. eine Ethernetschnittstelle 18, auf. Bei dem Ausführungsbeispiel gemäß Figur 1 weist das Prozessbusmodul 17a lediglich beispielhaft zwei Prozessbusschnittstellen 18 auf, die konkrete Anzahl von Prozessbusschnittstellen ist beliebig. Die digitalen Eingangs-Messwerte werden in dem Prozessbusmodul 17a in später detaillierter beschriebener Weise hinsichtlich ihrer Abtastrate und/oder ihrer Abtastzeitpunkte an eine vorgegebene Abtastrate und/oder vorgegebene Abtastzeitpunkte unter Bildung von digitalen Ausgangs-Messwerten $M_A$ angepasst und ausgangsseitig für eine weitere Verarbeitung bereitgestellt.

Das Automatisierungsgerät 11 weist neben dem Prozessbusmodul 17a auch ein Prozessormodul 17b und ein Analogeingangsmodul 17c auf. Die einzelnen Module 17a-17c sind über einen internen Kommunikationsbus 19 miteinander verbunden, über den interne Daten ausgetauscht werden und auch eine Zeitsynchronisation der einzelnen Module 17a-17c durchgeführt wird, so dass alle Module 17a-17c des Automatisierungsgerätes 11 dieselbe Systemzeit verwenden.

Das Analogeingangsmodul 17c ist direkt mit an einer weiteren Messstelle 13c des elektrischen Energieversorgungsnetzes angeordneten Messwandlern verbunden und nimmt von diesen beispielsweise ein analoges Stromsignal $i_5$ und ein analoges Spannungssignal $u_3$ auf. Diese lokal erfassten analogen Messsignale werden einem Analog-Digital-Umsetzer des Analogeingangsmoduls 17c zugeführt und dort in lokale digitale Messwerte $M_{lok}$ umgesetzt. Dazu wird beispielsweise ein Abtasttakt von 16kHz verwendet, der über die Systemzeit gesteuert und durch ein externes Zeitsynchronisationssignal (z.B. 1PPS-Impuls) mit anderen Signalen genau in Vergleich gesetzt werden kann.

Die lokalen digitalen Messwerte $M_{lok}$ werden ebenso wie die über von dem Prozessbusmodul 17a bereitgestellten digitalen Ausgangs-Messwerte $M_A$ von dem Prozessormodul 17b zur Ausführung von Steuer-, Überwachungs- und/oder Schutzfunktionen für das elektrische Energieversorgungsnetz verwendet. Handelt es sich bei dem Automatisierungsgerät 11 beispielsweise um ein elektrisches Schutzgerät, so werden von dem Prozessormodul 17b unter anderem Schutzalgorithmen, wie z.B. ein Distanzschutzalgorithmus oder ein Differentialschutzalgorithmus, durchgeführt, um Fehler in dem elektrischen Energieversorgungsnetz erkennen und abschalten zu können.

Zur Durchführung der Funktionen benötigt das Prozessormodul 17b miteinander vergleichbare Messwerte, d.h. die vom Prozessbusmodul 17a empfangenen digitalen Eingangs-Messwerte $M_E$ müssen hinsichtlich ihrer Abtastrate und/oder ihres Abtastzeitpunktes an die aus den lokal erfassten analogen Signalen gebildeten lokalen digitalen Messwerten $M_{lok}$ angepasst werden. Im vorliegenden Fall sollen beispielhaft sowohl die Abtastrate als auch die Abtastzeitpunkte der digitalen Eingangs-Messwerte $M_E$ und der lokalen digitalen Messwerte $M_{lok}$ voneinander abweichen, da einerseits in den Merging Units 12a-b eine andere Abtastrate als im Automatisierungsgerät 11 verwendet werde (4 kHz anstelle von 16 kHz) und andererseits die Abtastzeitpunkte der einzelnen Messwertverläufe nicht miteinander synchronisiert seien. Daher müssen die über das Prozessbusmodul 17a empfangenen digitalen Eingangs-Messwerte $M_E$ vor ihrer Weitergabe an das Prozessormodul 17b mittels eines digitalen Messeingangs 20 unter Bildung der digitalen Ausgangs-Messwerte $M_A$ hinsichtlich ihrer Abtastrate und ihrer Abtastzeitpunkte an die lokalen digitalen Messwerte $M_{lok}$ angepasst werden.

In Figur 1 ist das Automatisierungsgerät 11 lediglich beispielhaft als modular aufgebautes Gerät dargestellt; dieser Aufbau ist jedoch für die Erfindung unerheblich, so dass auch nicht modulare Automatisierungsgeräte oder Geräte mit einer anderen Modulaufteilung verwendet werden können. Außerdem muss auch ein analoger Messeingang nicht zwingend vorhanden sein, es ist gleichsam ausreichend, wenn ausschließlich der digitale Messeingang 20 vorhanden ist. Darüber hinaus können auch mehrere digitale Messeingänge vorhanden sein, die entsprechend dem nachfolgend beschriebenen digitalen Messeingang 20 aufgebaut sind. Außerdem ist es möglich, Datentelegramme mehrerer Messkanäle mit demselben digitalen Messeingang zu erfassen und intern, z.B. durch geeignetes Multiplexing, auf die individuellen Messkanäle aufzuteilen. Bei einem Vorhandensein von mehreren digitalen Messeingängen können die hierüber erfassten digitalen Eingangs-Messwerte unterschiedliche Abtastzeitpunkte und/oder unterschiedliche Abtastfrequenzen aufweisen.

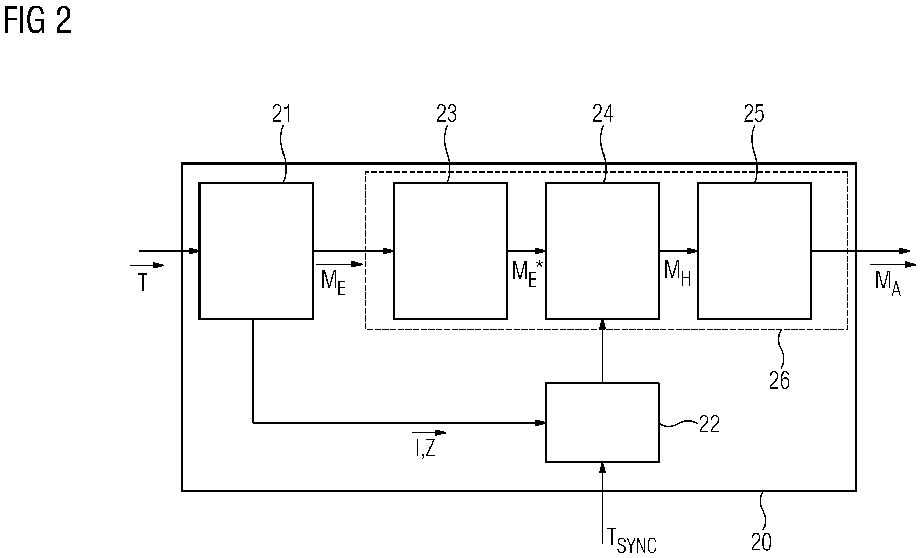

Die Funktionsweise des digitalen Messeingangs 20 wird nachfolgend anhand von Figur 2 näher erläutert. Dabei zeigt Figur 2 einzelne Komponenten des digitalen Messeingangs 20 in separater Darstellung. Diese können als einzelne oder kombinierte Hardware- oder Sofwarebausteine oder eine Kombination daraus ausgebildet sein.

Figur 2 zeigt den digitalen Messeingang 20, der beispielsweise Bestandteil des Prozessbusmoduls 17a (vgl. Figur 1) sein kann. Der digitale Messeingang 20 weist unter anderem eine Empfangseinrichtung 21 zum Empfangen der die digitalen Eingangs-Messwerte $M_E$ enthaltenden Datentelegramme T und eine Signalumsetzeinrichtung 26 zur Verarbeitung der empfangenen digitalen Eingangs-Messwerte $M_E$ auf. Die Empfangseinrichtung 21 extrahiert die digitalen Eingangs-Messwerte $M_E$ aus den Datentelegrammen T und weist sie den einzelnen analogen Messsignalen der Merging Units 12a-b zu. Dabei entstehen für jedes analoge Messsignal individuelle Verläufe digitaler Eingangs-Messwerte $M_E$. Diese können der weiteren Verarbeitung beispielsweise durch ein geeignetes Multiplexing zugeführt werden. Das nachfolgend beschriebene Verfahren zum Verarbeiten der digitalen Eingangs-Messwerte $M_E$ wird der Einfachheit halber beispielhaft nur für die digitalen Eingangs-Messwerte $M_E$ eines einzelnen analogen Messsignals erläutert.

Neben den digitalen Eingangs-Messwerten $M_E$ selbst entnimmt die Empfangseinrichtung 21 auch eine Information I über die Abtastrate, mit der die digitalen Eingangs-Messwerte $M_E$ in der Merging Unit 12a-b erzeugt worden sind und über den Abtastzeitpunkt Z des jeweiligen digitalen Eingangs-Messwerts $M_E$ aus den Datentelegrammen T. Beispielsweise kann die Information I über die verwendete Abtastrate direkt in einem, in einigen oder in allen Datentelegrammen T enthalten sein. Alternativ kann die Empfangseinrichtung 21 die Information auch wie oben bereits erläutert indirekt über den digitalen Eingangs-Messwerten $M_E$ zugeordnete Zeitstempel oder Zählwerte entnehmen. Die Information Z über den Abtastzeitpunkt kann beispielsweise aus einem Zeitstempel oder einem Zählwert abgeleitet werden.

Die Informationen I und Z über die Abtastrate und den Abtastzeitpunkt der digitalen Eingangs-Messwerte $M_E$ werden von der Empfangseinrichtung 21 einer Zeitsteuereinrichtung 22 des digitalen Messeingangs 20 übergeben. Bei nur indirekt ermittelbaren Informationen I und/oder Z kann alternativ die Empfangseinrichtung 21 auch die Zeitstempel oder die Zählwerte der digitalen Eingangs-Messwerte $M_E$ direkt an die Zeitsteuereinrichtung 22 übergeben, die daraufhin selbst die Informationen I und oder Z über die Abtastrate I bzw. die jeweiligen Abtastzeitpunkte ermittelt.

Der Zeitsteuereinrichtung 22 wird darüber hinaus auch ein die Systemzeit angebende internes Zeitsignal $T_{Sync}$ des Automatisierungsgerätes 11 zugeführt. Anhand der Informationen über die Abtastzeitpunkte der digitalen Messwerte einerseits und die Systemzeit andererseits kann bei bekannter zeitlicher Verzögerung durch die Abtastung in der Merging Unit 12a-b und die Übertragung zwischen Merging Unit 12a-b und Automatisierungsgerät 11 einerseits ein zeitlicher Versatz zwischen der Systemzeit und den Abtastzeitpunkten der digitalen Eingangs-Messwerte $M_E$ ermittelt werden und andererseits ein Bezug zwischen den auf der Zeitbasis der jeweiligen Merging Unit 12a-b beruhenden digitalen Eingangs-Messwerte $M_E$ und den in der Signalumsetzeinrichtung 26 zu bildenden, auf der Systemzeit des Automatisierungsgerätes 11 beruhenden digitalen Ausgangs-Messwerten $M_A$ hergestellt werden.

Die aus den Datentelegrammen T entnommenen digitalen Eingangs-Messwerte $M_E$ werden von der Empfangseinrichtung 21 an die Signalumsetzeinrichtung 26 übergeben, die eingangsseitig einen digitalen Encoder-Filter 23 aufweist. Der Encoder-Filter kann beispielsweise eine Übertagungsfunktion mit einer PD-Charakteristik aufweisen. Die digitalen Eingangs-Messwerte $M_E$ werden in dem digitalen Encoder-Filter 23 unter Bildung von encodierten digitalen Eingangs-Messwerten $M_E^*$ gefiltert. Nach der Filterung mit dem Encoder-Filter 23 werden die encodierten digitalen Messwerte $M_E^*$ einem Interpolator 24 zugeführt, der unter Verwendung eines Signalmodells auf Basis der encodierten digitalen Messwerte $M_E^*$ unter Bildung von digitalen Hilfsmesswerten $M_H$ eine Interpolation durchführt und dabei die encodierten digitalen Eingangs-Messwerte $M_E^*$ hinsichtlich ihrer Abtastrate und ihres jeweiligen Abtastzeitpunktes an die geforderte Abtastrate und die geforderten Abtastzeitpunkte anpasst. Hierzu nutzt der Interpolator 24 die von der Zeitsteuereinrichtung 22 bereitgestellten Informationen über die Abtastrate bzw. die Abtastzeitpunkte der digitalen Messwerte einerseits und die Systemzeit andererseits. Der Interpolator 24 berechnet beispielsweise anhand der encodierten digitalen Eingangs-Messwerte $M_E^*$ durch Interpolation digitale Hilfsmesswerte $M_H$ mit einer Abtastrate von 16kHz zu durch die Systemzeit vorgegebenen Abtastzeitpunkten. Die digitalen Hilfsmesswerte $M_H$ werden vom Interpolator 24 ausgangsseitig an einen Decoder-Filter 25 weitergegeben, der beispielsweise eine Tiefpasscharakteristik aufweist. Der Decoder-Filter 25 übernimmt hierbei unter anderem die Funktion einer Bandbegrenzung, indem nicht gewünschte hohe Frequenzanteile gedämpft werden. Ausgangsseitig gibt der Decoder-Filter 25 die digitalen Ausgangs-Messwerte $M_A$ ab, die hinsichtlich ihrer Abtastrate und ihrer Abtastzeitpunkte an die zur Weiterverarbeitung in der Prozessorbaugruppe 17b (vgl. Figur 1) geforderten Werte angepasst sind. Insbesondere entsprechen Abtastrate und Abtastzeitpunkte der digitalen Ausgangs-Messwerte $M_A$ nach der Verarbeitung in der Signalumsetzeinrichtung 26 der zur Bildung der lokalen digitalen Messwerte $M_{lok}$ verwendeten Abtastrate und den Abtastzeitpunkten der lokalen digitalen Messwerte $M_{lok}$.

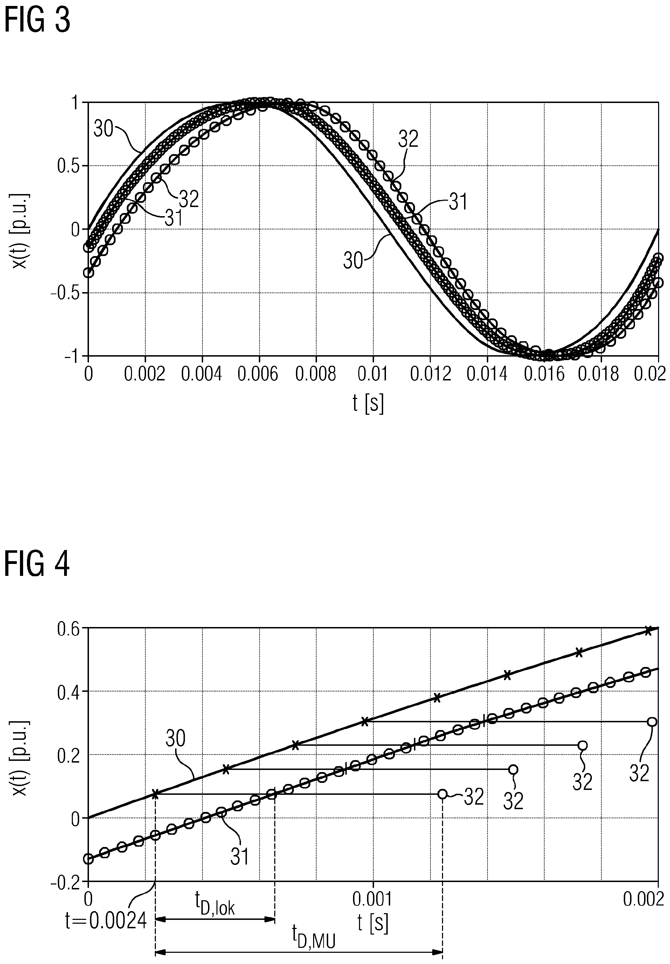

Die Übertragungsfunktionen des Encoder-Filters 23 und des Decoder-Filters 25 können vorteilhafterweise derart aufeinander abgestimmt sein, dass die sich ergebende Summenübertragungsfunktion durch Beeinflussung des Phasengangs der digitalen Eingangs-Messwerte $M_E$ eine Anpassung der zeitlichen Verzögerung der gebildeten digitalen Ausgangs-Messwerte $M_A$ an die lokalen digitalen Messwerte $M_{lok}$ bewirkt. Dies ist in Figuren 3 und 4 näher erläutert.

Hierzu ist in Figur 3 in einem Diagramm zum Einen der normierte (p.u. = per unit) Verlauf eines analogen Messsignals 30 im Energieversorgungsnetz über der Zeit t dargestellt. Zum Anderen sind in dem Diagramm ein durch lokale Abtastung des analogen Messsignals 30 im Automatisierungsgerät erzeugter Verlauf 31 von lokalen digitalen Messwerten $M_{lok}$ und ein durch Abtastung des analogen Messsignals 30 in einer Merging Unit und anschließende Übertragung zum Automatisierungsgerät erzeugter Verlauf 32 von digitalen Eingangs-Messwerten $M_E$ gezeigt. Bei den Verläufen 31 und 32 wird ein Abtastwert jeweils durch eine Ellipse angedeutet.

Die Verläufe 31 und 32 sind im Vergleich zum analogen Messsignal 31 zeitlich verschoben; die jeweilige zeitliche Verschiebung resultiert aus der Verarbeitungszeit bei der Abtastung und ggf. aus der Übertragungszeit. Man erkennt einerseits, dass die lokalen digitalen Messwerte $M_{lok}$ mit einer deutlich höheren Abtastrate erzeugt worden sind (die Ellipsen liegen dichter beieinander) als die digitalen Eingangs-Messwerte $M_E$ der Merging Unit. Andererseits wird auch ersichtlich, dass durch die Abtastung in der Merging Unit und die anschließende Übertragung der digitalen Eingangs-Messwerte $M_E$ der Verlauf 32 eine deutlich größere zeitliche Verschiebung zum analogen Messsignal 30 aufweist als der Verlauf 31 der lokalen digitalen Messwerte $M_{lok}$. Dies ist in Figur 4 noch einmal hervorgehoben. In Figur 4 ist hierzu der Bereich des Diagramms aus Figur 3 zwischen t=0s und t=0.002s ausschnittsweise vergrößert hervorgehoben. Man erkennt wiederum die Verläufe 30, 31 und 32 des analogen Signals, der lokalen digitalen Messwerte $M_{lok}$ und der digitalen Eingangs-Messwerte $M_E$. Eingezeichnet sind zudem für den Zeitpunkt t=0.0024s einerseits die Zeitverzögerung $t_{D,lok}$ bis zur Erzeugung eines entsprechenden lokalen digitalen Messwertes $M_{lok}$ sowie die Zeitverzögerung $t_{D,MU}$ bis zur Erzeugung eines digitalen Eingangs-Messwertes $M_E$ durch die Merging Unit und dessen Übertragung zum Automatisierungsgerät.

Um die beiden Verläufe 31 und 32 miteinander vergleichen zu können, müssen durch die Signalumsetzeinrichtung 26 (vgl. Fig. 2) einerseits die Abtastrate und Abtastzeitpunkte der digitalen Eingangs-Messwerte $M_E$ und der lokalen digitalen Messwerte $M_{lok}$ aneinander angepasst werden und andererseits die zeitliche Verzögerung bei der Bereitstellung der jeweiligen Messwerte im Automatisierungsgerät vereinheitlicht werden. Um insgesamt eine möglichst kurze Ansprechzeit des Automatisierungsgerätes zu gewährleisten, wird hierzu als Referenzsignal der Verlauf 31 der lokalen digitalen Messwerte $M_{lok}$ gewählt.

Durch den Interpolator werden hierzu einerseits die Abtastrate der digitalen Eingangs-Messwerte $M_E$ entsprechend erhöht und andererseits deren Abtastzeitpunkte mit denen der lokalen digitalen Messwerte $M_{lok}$ synchronisiert. Durch das Zusammenwirken des Encoder-Filters und des Decoder-Filters wird der Phasengang der digitalen Eingangs-Messwerte $M_E$ entsprechend beeinflusst, um die Differenz $t_{D,MU}$ - $t_{D,lok}$ der beiden zeitlichen Verzögerungen der Verläufe 31 und 32 auszugleichen. Damit wird der Verlauf 32 der digitalen Eingangs-Messwerte $M_E$ quasi mit dem Verlauf 31 der lokalen digitalen Messwerte $M_{lok}$ in Überdeckung gebracht.

Mittels des Encoder-Filters werden zusammengefasst also die von der Merging Unit empfangenen digitalen Eingangs-Messwerte $M_E$ ohne vorherige Abtastratenkonvertierung gefiltert. Aus den entstehenden encodierten digitalen Eingangs-Messwerten $M_E^*$ werden mittels des Interpolators digitale Hilfsmesswerte $M_H$ zu den gewünschten neuen Abtastzeitpunkten mit der gewünschten neuen Abtastrate aus den encodierten digitalen Messwerten $M_E^*$ gebildet. Der aus den digitalen Hilfsmesswerten $M_H$ bestehende neue Abtastwertestrom wird mittels des Decoder-Filters in die digitalen Ausgangsmesswerte $M_A$ der neuen Abtastrate umgewandelt.

Wenn durch die Signalverarbeitung in der Signalumsetzeinrichtung keine zeitliche Verschiebung gewünscht wird, bildet die Faltung der Übertragungsfunktionen des Encoder-Filters und des Decoder-Filters im Zeitbereich den Wert 1. Das ist immer dann möglich, wenn die Abtastraten vor und nach der Interpolation gleich sind oder nach der Interpolation eine höhere Abtastrate verwendet wird. Weiterhin kann durch Wahl einer Summenübertragungsfunktion mit vorgegebener frequenzabhängiger oder konstanter Gruppenlaufzeit für die gefalteten Übertragungsfunktionen des Encoder-Filters und des Decoder-Filters eine frequenzabhängige zeitliche Verschiebung so eingestellt werden, dass die entstehende Gruppenlaufzeit der digitalen Eingangs-Messwerte $M_E$ an die Gruppenlaufzeit der lokalen digitalen Messwerte $M_{lok}$ exakt angepasst wird. Auf diese Weise kann quasi eine Anpassung der Übertragungscharakteristik der von einer Merging Unit empfangenen digitalen Eingangs-Messwerte $M_E$ an die Übertragungscharakteristik der lokalen digitalen Messwerte $M_{lok}$ erfolgen. Ist die Gruppenlaufzeit der digitalen Eingangs-Messwerte $M_E$ von der Merging Unit bereits größer als die Gruppenlaufzeit der lokalen digitalen Messwerte $M_{lok}$, kann die Gruppenlaufzeit der Eingangs-Messwerte $M_E$ auch auf ein ganzzahliges Vielfaches der Gruppenlaufzeit der lokalen digitalen Messwerte $M_{lok}$ eingestellt werden. Ein Verzögern des Wertstroms der lokalen digitalen Messwerte um die Anzahl Abtastwerte, die der Differenz der beiden Gruppenlaufzeiten entspricht, liefert dann zueinander synchrone Werteströme.

Die Interpolation erfolgt auf der Basis eines Signalmodells, so dass im interpolierten Verlauf der digitalen Hilfsmesswerte $M_H$ Interpolationsfehler nur oberhalb der halben ursprünglichen Abtastfrequenz erzeugt und diese Interpolationsfehler durch das Decoder-Filter so weit gedämpft werden, dass die Interpolationsfehler in dem am Ausgang des Decoder-Filters bereitstehenden Verlauf von digitalen Ausgangs-Messwerten $M_A$ eine Amplitude unterhalb der geforderten Signalauflösung aufweisen.

Hinsichtlich der Auslegung der Filter können beispielsweise folgende Überlegungen angestellt werden: Das beschriebene Verfahren kann z.B. durch die Verwendung von digitalen IIR-Filtern für den Encoder-Filter und den Decoder-Filter realisiert werden. Wenn durch die beiden Filter insgesamt keine zeitliche Verschiebung des Verlaufes der digitalen Eingangs-Messwerte erfolgen soll, ist die folgende Summenübertragungsfunktion im Frequenzbereich zu verwenden:

$$G(j\omega) = G_{Enc}(j\omega) \cdot G_{Dec}(j\omega) = 1.$$

Hierbei stehen

$G(j\omega)$ für die Summenübertragungsfunktion im Frequenzbereich,
$G_{Enc}(j\omega)$ für die Übertragungsfunktion des Encoder-Filters,
$G_{Dec}(j\omega)$ für die Übertragungsfunktion des Decoder-Filters,
$\omega$ für die Kreisfrequenz und
j für die imaginäre Zahl.

Für die Reihenschaltung des Encoder-Filters und des Decoder-Filters wird in diesem Fall also eine Summenübertragungsfunktion angestrebt, die das Signal nicht verändert. Das ist immer dann möglich, wenn die Abtastraten vor und nach der Interpolation gleich sind oder nach der Interpolation eine höhere Abtastrate verwendet wird. Weiterhin kann durch Wahl einer Summenübertragungsfunktion mit vorgegebener frequenzabhängiger oder konstanter Gruppenlaufzeit für die gefalteten Übertragungsfunktionen des Encoder-Filters und des Decoder-Filters eine frequenzabhängige zeitliche Verschiebung so eingestellt werden, dass die entstehende Gruppenlaufzeit der digitalen Eingangs-Messwerte an die Gruppenlaufzeit der lokalen digitalen Messwerte exakt angepasst wird. Auf diese Weise kann eine Anpassung der Übertragungscharakteristik der von der Merging Unit empfangenen digitalen Eingangs-Messwerte an die Übertragungscharakteristik der lokalen digitalen Messwerte erfolgen.

Im Falle einer im Vergleich zur ursprünglichen Abtastrate niedrigeren Abtastrate der digitalen Ausgangs-Messwerte muss eine Tiefpass-Charakteristik für die Summenübertragungsfunktion beider Filter mit den entsprechend gewünschten Anti-Aliasing-Eigenschaften gewählt werden.

Beispielsweise kann für den Encoder-Filter eine Übertragungsfunktion

$$G_{Enc}(j\omega) = \left(\frac{1 + j\omega T_o}{1 + j\omega T_u}\right)^{n}$$

verwendet werden. Hierbei stehen

$T_o$ für eine obere Zeitkonstante des Filters,
$T_u$ für eine untere Zeitkonstante des Filters und
n für die Filterordnung.

Für den Decoder-Filter kann entsprechend die Übertragungsfunktion

$$G_{Enc}(j\omega) = \left(\frac{1 + j\omega T_u}{1 + j\omega T_o}\right)^{n}$$

gewählt werden. Mittels Bilineartransformation (siehe z.B. http://en.wikipedia.org/wiki/Bilinear_transform) lassen sich aus den oben angegeben analogen Übertragungsfunktionen digitale IIR-Filter entwerfen, die eine Realisierung der Filter mittels Differenzengleichungen der Form

$$y_{(k)} = \sum_{i=0}^{n} B_i \cdot x_{(k-i)} - \sum_{m=1}^{n} A_m \cdot y_{(k-m)}$$

gestatten. Hierbei stehen

A und B für die Filterkoeffizienten,
k für den Zählwert des jeweiligen Messwertes,
x für die am Eingang des Filters vorliegenden Messwerte und
y für die ausgangsseitig am Filter abgegebenen Messwerte.

Durch die individuelle Vorgabe der Koeffizienten A und B für die einzelnen Filter kann die Summenübertragungsfunktion insgesamt in der gewünschten Weise beeinflusst werden. Sofern der digitale Messeingang als ASIC oder FPGA ausgebildet ist, können die Filterkoeffizienten z.B. in einem Speicherregister des fraglichen Bausteins veränderbar vorgegeben werden.
Für die Filter können beispielsweise folgende Parameter verwendet werden:

$$n = 1, \quad T_o = \frac{1}{2 \cdot \pi \cdot 2000}, \quad T_u = \frac{1}{2 \cdot \pi \cdot 50}.$$

Für den Interpolator kann beispielsweise ein Signalmodell in Form einer quadratischen Funktion verwendet werden:

$$y_{(k)} = a \cdot x_{(k)}^{2} + b \cdot x_{(k)} + c.$$

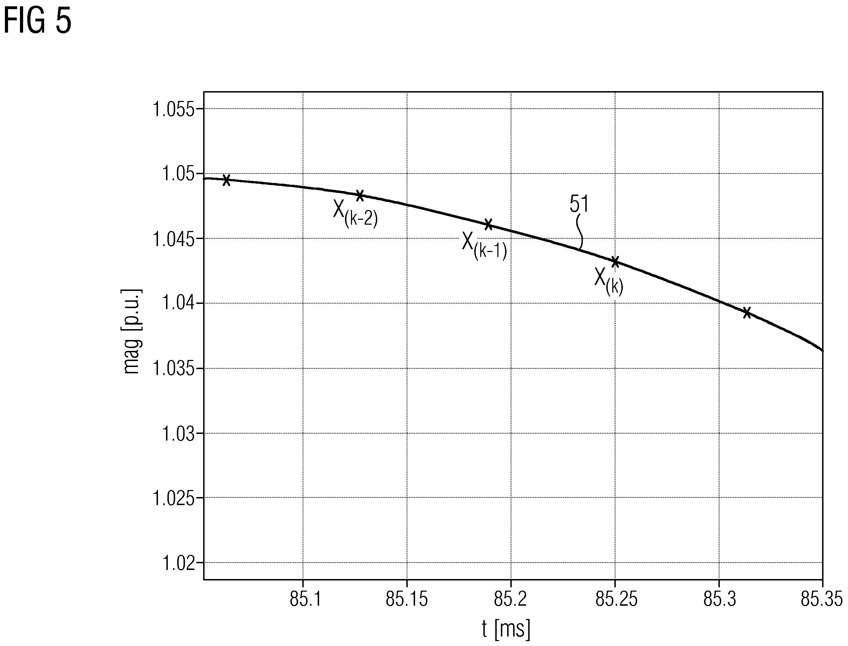

Die Interpolator-Koeffizienten a, b und c können mittels Koeffizientenvergleich aus den letzten drei Abtastwerten des am Eingang des Interpolators vorliegenden Datenstroms gebildet werden. Dies ist beispielhaft in Figur 5 dargestellt, die ein Diagramm mit einem Verlauf von encodierten digitalen Eingangs-Messwerten $x_{(k-2)}$, $x_{(k-1)}$ und $x_{(k)}$ sowie mit einem interpolierten Verlauf 51 zeigt. Die Koeffizienten a, b, c können wie folgt bestimmt werden:

$$c = x_{(k-2)}, \quad a = \frac{2 \cdot x_{(k-1)} - x_{(k)} - c}{2 \cdot t_a^{2}}, \quad b = \frac{x_{(k-1)} - a \cdot t_a^{2} - c}{t_a}.$$

Als $t_a$ wird hier der durch die Abtastrate vorgegebene zeitliche Abstand zwischen zwei digitalen Messwerten bezeichnet. Der Bezugspunkt für t=0 der berechneten Koeffizienten des Signalmodells ist hier $x_{(k-2)}$. Aus den am Eingang des Interpolators vorliegenden encodierten digitalen Eingangs-Messwerten $M_E^*$ können nun unter Nutzung des Signalmodells in der oben angegeben Form die digitalen Hilfsmesswerte $M_H$ des ausgangsseitig vom Interpolator abgegebenen Verlaufs für die gewünschten Abtastzeitpunkte berechnet werden. Für diese kann auch eine andere Abtastrate gewählt werden, z.B. kann eine Erhöhung der Abtastrate von 4kHz auf 16kHz stattfinden.

Durch die Interpolation werden im Verlauf der ausgangsseitig vorliegenden Hilfsmesswerte $M_H$ zusätzliche Spektralanteile erzeugt, die im Originalsignal nicht enthalten waren. Diese Spektralanteile werden anschließend durch die Filterung mit dem Decoder-Filter soweit unterdrückt, dass die durch die Interpolation induzierten Harmonischen vernachlässigt werden können.

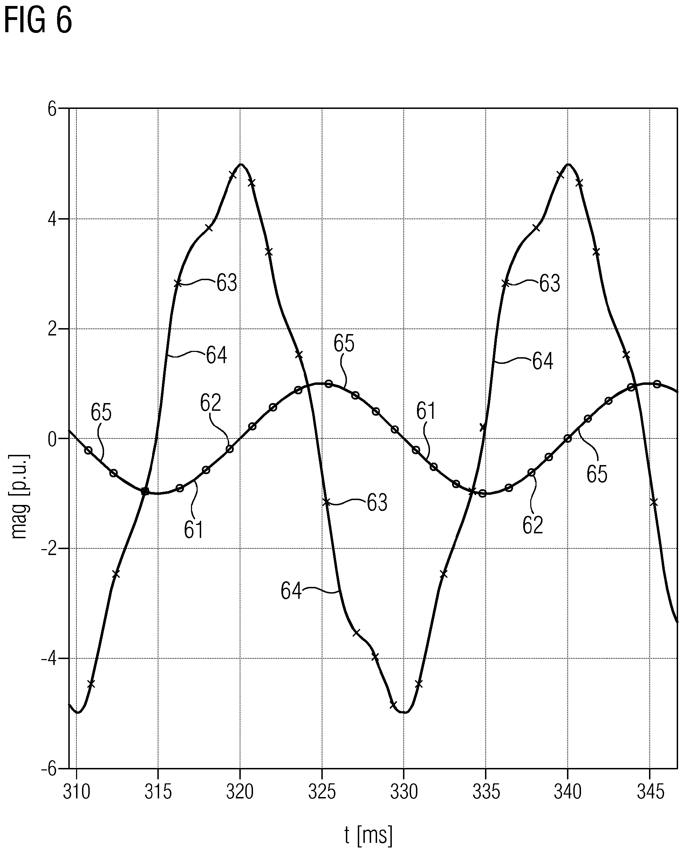

Figur 6 zeigt schließlich die Verläufe eines Messsignals an unterschiedlichen Stellen der Verarbeitungskette. Mit dem Bezugszeichen 61 ist in Figur 6 der Verlauf des analogen Messsignals vor der Abtastung durch die Merging Unit bezeichnet. Bei der Abtastung werden durch Kreise angedeutete digitale Eingangs-Messwerte 62 erzeugt und an das Automatisierungsgerät übertragen. Im Encoder-Filter der Signalumsetzeinrichtung wird aus dem am Filtereingang anliegenden Verlauf der digitalen Eingangs-Messwerte 62 ein Verlauf encodierter digitaler Eingangs-Messwerte 63 (in Figur 6 durch Kreuze angedeutet) erzeugt und an den Interpolator übergeben. Der Interpolator passt den Verlauf encodierter digitaler Eingangs-Messwerte 63 hinsichtlich Abtastrate und/oder Abtastzeitpunkten an die gewünschten Parameter an und erzeugt ausgangsseitig einen Verlauf 64 von digitalen Hilfsmesswerten. Diese werden abschließend dem Decoder-Filter zugeführt, der ausgangsseitig einen hinsichtlich Abtastrate und Abtastzeitpunkten angepassten Verlauf 65 von digitalen Ausgangs-Messwerten abgibt. Wie aus Figur 6 ersichtlich, liegt dieser Verlauf 65 wie gewünscht in Überdeckung mit dem analogen Messsignal 61.

Der digitale Messeingang wird erfindungsgemäß vorzugsweise mittels einer VHDL- oder Schematics-Implementierung in einem FPGA oder einem ASIC realisiert, um etwaige Verzögerungen durch eine Firmware-Implementierung zu verhindern.

Mit dem beschriebenen digitalen Messeingang eines Automatisierungsgerätes sowie dem beschriebenen Verfahren zur Verarbeitung digitaler Eingangs-Messwerte kann einerseits für jeden eingehenden Verlauf digitaler Eingangs-Messwerte eine Anpassung von Abtastrate und/oder Abtastzeitpunkten stattfinden. Darüber hinaus ist es wie erläutert möglich, die digitalen Eingangs-Messwerte an vom Automatisierungsgerät direkt abgetastete lokale digitale Messwerte anzupassen. Außerdem können mehrere Verläufe digitaler Eingangs-Messwerte aufeinander angepasst werden. Dabei können die jeweils verwendeten Merging Units unterschiedliche Abtastraten sowie unterschiedliche Abtastzeitpunkte verwenden, so dass auch beim Ausfall einer externen Synchronisierung durch die beschriebene Bildung digitaler Ausgangs-Messwerte die Verwendbarkeit der digitalen Eingangs-Messwerte gewährleistet bleibt.

Auch ist es im Rahmen der Erfindung denkbar, dass mehrere externe Zeitsynchronisiersignale für jeweils eine Merging Unit oder eine Gruppe von Merging Units verwendet werden. Diese Zeitsynchronisationssignale können von den Merging Units auch selbst generiert werden. Auf diese Weise können dann die von diesen Merging Units gelieferten Eingangs-Messwerte auch dann noch mit lokalen digitalen Messwerten synchronisiert werden, wenn das Zeitsynchronisationssignal zur Synchronisation der Merging Units ausfällt.

**Patentansprüche**

1.  Digitaler Messeingang (20) für ein elektrisches Automatisierungsgerät (11), mit

    - einer Empfangseinrichtung (21), die zum Empfang digitaler Eingangs-Messwerte eingerichtet ist, die durch Abtastung eines analogen Messsignals mit einer ersten Abtastrate erzeugt worden sind; und
    - einer Signalumsetzeinrichtung (26), die dazu ausgebildet ist, aus den digitalen Eingangs-Messwerten digitale Ausgangs-Messwerte zu bilden und bereitzustellen, wobei die digitalen Ausgangs-Messwerte hinsichtlich ihrer Abtastrate und/oder ihres jeweiligen Abtastzeitpunktes an eine vorgegebene Abtastrate und/oder vorgegebene Abtastzeitpunkte angepasst sind, wobei
    - die Signalumsetzeinrichtung (26) eingangsseitig einen digitalen Encoder-Filter (23) und ausgangsseitig einen digitalen Decoder-Filter (25) aufweist, zwischen denen ein Interpolator (24) vorgesehen ist, **dadurch gekennzeichnet, dass**
    - der Encoder-Filter (23), der Interpolator (24) und der Decoder-Filter (25) derart aufeinander abgestimmt sind, dass durch sie die Anpassung der digitalen Eingangs-Messwerte hinsichtlich Abtastrate und/oder Abtastzeitpunkten bewirkt wird.

2.  Digitaler Messeingang (20) nach Anspruch 1,
    **dadurch gekennzeichnet, dass**

- der Interpolator (24) zur Erzeugung von interpolierten digitalen Hilfsmesswerten unter Verwendung eines Signalmodells eingerichtet ist.

3. Digitaler Messeingang (20) nach Anspruch 2, **dadurch gekennzeichnet, dass**

- das Signalmodell eine quadratische Funktion beschreibt.

4. Digitaler Messeingang (20) nach einem der vorangehenden Ansprüche, d**adurch gekennzeichnet,** dass

- der Encoder-Filter (23) und der Decoder-Filter (25) individuelle Übertragungsfunktionen aufweisen, die derart aufeinander abstimmbar sind, dass ihre gemeinsame Übertragungsfunktion eine einstellbare Verschiebung des Phasengangs der Abfolge digitaler Eingangs-Messwerte zur Erzeugung einer gewünschten zeitlichen Verschiebung der digitalen Ausgangs-Messwerte im Vergleich zu den digitalen Eingangs-Messwerten bewirkt.

5. Digitaler Messeingang (20) nach einem der vorangehenden Ansprüche, **dadurch gekennzeichnet, dass**

- der Encoder-Filter (23) eine PD-Charakteristik aufweist und der Decoder-Filter (25) eine Tiefpasscharakterisitk aufweist.

6. Digitaler Messeingang (20) nach einem der vorangehenden Ansprüche, **dadurch gekennzeichnet, dass**

- der digitale Messeingang (20) in Form eines Verarbeitungsbausteins mit hardwarebestimmter Programmierung, insbesondere eines ASICs oder eines FPGAs, ausgebildet ist.

7. Digitaler Messeingang (20) nach Anspruch 6, **dadurch gekennzeichnet, dass**

- der Verarbeitungsbaustein ein Speicherregister aufweist, in dem Filterkoeffizienten des Encoder-Filters und/oder des Decoder-Filters veränderbar abgespeichert sind.

8. Digitaler Messeingang (20) nach einem der vorangehenden Ansprüche, **dadurch gekennzeichnet, dass**

- die Empfangseinrichtung (21) zum Empfang der digitalen Eingangs-Messwerte in Form von Datentelegrammen ausgebildet ist.

9. Digitaler Messeingang (20) nach Anspruch 8, **dadurch gekennzeichnet, dass**

- die Empfangseinrichtung (21) dazu eingerichtet ist, den die digitalen Eingangs-Messwerte enthaltenden Datentelegrammen eine Information über die erste Abtastrate zu entnehmen und diese an die Signalumsetzeinrichtung (26) weiterzugeben.

10. Elektrisches Automatisierungsgerät (11) mit einem digitalen Messeingang (20) nach einem der vorangehenden Ansprüche 1 bis 9.

11. Elektrisches Automatisierungsgerät (11) nach Anspruch 10, **dadurch gekennzeichnet, dass**

- das elektrische Automatisierungsgerät (11) zumindest einen analogen Signaleingang aufweist, der zur Erfassung eines lokalen analogen Messsignals und zur Bildung lokaler digitaler Messwerte eingerichtet ist; und
- die Signalumsetzeinrichtung (26) des digitalen Messeingangs (20) derart ausgebildet ist, zur Anpassung der digitalen Eingangs-Messwerte hinsichtlich Abtastrate und/oder Abtastzeitpunkten die Abtastrate und/oder die Abtastzeitpunkte der lokalen digitalen Messwerte als vorgegebene Abtastrate und/oder vorgegebene Abtastzeitpunkte zu verwenden.

**12.** Elektrisches Automatisierungsgerät (11) nach einem der Ansprüche 10 oder 11, **dadurch gekennzeichnet, dass**

- das Automatisierungsgerät (11) zumindest einen weiteren digitalen Messeingang aufweist, der entsprechend dem digitalen Messeingang (20) ausgebildet sind.

**13.** Elektrisches Automatisierungsgerät (11) nach einem der Ansprüche 10 oder 11, **dadurch gekennzeichnet, dass**

- der digitale Messeingang (20) zum Empfang und zur Verarbeitung mehrerer Verläufe digitaler Eingangs-Messwerte ausgebildet ist.

**14.** Verfahren zum Verarbeiten von digitalen Eingangs-Messwerten, die durch Abtastung eines analogen Messsignals mit einer ersten Abtastrate erzeugt worden sind, wobei bei dem Verfahren

- mit einer Empfangseinrichtung (21) eines digitalen Messeingangs (20) eines Automatisierungsgerätes (11) die digitalen Eingangs-Messwerte empfangen werden; und
- mit einer Signalumsetzeinrichtung (26) des digitalen Messeingangs (20), aus den digitalen Eingangs-Messwerten digitale Ausgangs-Messwerte gebildet und bereitgestellt werden, wobei die digitalen Ausgangs-Messwerte hinsichtlich ihrer Abtastrate und/oder ihres jeweiligen Abtastzeitpunktes an eine vorgegebene Abtastrate und/oder vorgegebene Abtastzeitpunkte angepasst, wobei
- die digitalen Eingangs-Messwerte mit einem digitalen Encoder-Filter (23) der Signalumsetzeinrichtung (26) unter Bildung von encodierten digitalen Eingangs-Messwerten gefiltert werden,
- die encodierten digitalen Eingangs-Messwerte mit einem Interpolator (24) der Signalumsetzeinrichtung (26) unter Bildung von digitalen Hilfsmesswerten interpoliert werden; und
- die digitalen Hilfsmesswerte mit einem digitalen Decoder-Filter (25) der Signalumsetzeinrichtung (26) unter Bildung der digitalen Ausgangs-Messwerte gefiltert werden; **dadurch gekennzeichnet, dass**
- der Encoder-Filter (23), der Interpolator (24) und der Decoder-Filter (25) derart aufeinander abgestimmt sind, dass sie die Anpassung der digitalen Eingangs-Messwerte hinsichtlich Abtastrate und/oder Abtastzeitpunkten bewirken.

**15.** Verfahren nach Anspruch 14, d**adurch gekennzeichnet,** dass

- eine aus einer Verknüpfung der individuellen Übertragungsfunktionen des Encoder-Filters (23) und des Decoder-Filters (25) resultierende gemeinsame Übertragungsfunktion eine einstellbare Verschiebung des Phasengangs der Abfolge der digitalen Eingangs-Messwerte zur Erzeugung einer gewünschten zeitlichen Verschiebung der digitalen Ausgangs-Messwerte im Vergleich zu den digitalen Eingangs-Messwerten bewirkt.

**Claims**

**1.** Digital measurement input (20) for an electric automation device (11), with

- a receiving device (21) which is configured to receive digital input measurement values which have been generated by sampling an analog measurement signal at a first sampling rate; and
- a signal conversion device (26) which is designed to form and provide digital output measurement values from the digital input measurement values, wherein the sampling rate and/or respective sampling times of the digital output measurement values is/are adapted to a specified sampling rate and/or specified sampling times, wherein
- the signal conversion device (26) has a digital encoder filter (23) on the input side and a decoder filter (25) on the output side, between which an interpolator (24) is provided, **characterized in that**
- the encoder filter (23), the interpolator (24) and the decoder filter (25) are matched to one another so that the adaptation of the sampling rate and/or sampling times of the digital input measurement values is effected by them.

**2.** Digital measurement input (20) according to Claim 1, **characterized in that**

- the interpolator (24) is configured to generate interpolated digital auxiliary measurement values using a signal model.

3. Digital measurement input (20) according to Claim 2, **characterized in that**

   - the signal model describes a quadratic function.

4. Digital measurement input (20) according to one of the preceding claims,
   **characterized in that**

   - the encoder filter (23) and the decoder filter (25) have individual transmission functions which can be matched to one another so that their common transmission function effects an adjustable shift of the phase response of the sequence of digital input measurement values in order to generate a required temporal shift of the digital output measurement values compared to the digital input measurement values.

5. Digital measurement input (20) according to one of the preceding claims,
   **characterized in that**

   - the encoder filter (23) has a PD characteristic and the decoder filter (25) has a low-pass characteristic.

6. Digital measurement input (20) according to one of the preceding claims,
   **characterized in that**

   - the digital measurement input (20) is designed in the form of a processing module with hardware-defined programming, in particular an ASIC or an FPGA.

7. Digital measurement input (20) according to Claim 6,
   **characterized in that**

   - the processing module has a memory register in which filter coefficients of the encoder filter and/or the decoder filter are modifiably stored.

8. Digital measurement input (20) according to one of the preceding claims,
   **characterized in that**

   - the receiving device (21) is designed to receive the digital input measurement values in the form of data messages.

9. Digital measurement input (20) according to Claim 8,
   **characterized in that**

   - the receiving device (21) is configured to extract information relating to the first sampling rate from the data messages
   containing the digital input measurement values and forward said information to the signal conversion device (26).

10. Electric automation device (11) with a digital measurement input (20) according to one of the preceding Claims 1 to 9.

11. Electric automation device (11) according to Claim 10, **characterized in that**

    - the electric automation device (11) has at least one analog signal input which is configured to capture a local analog measurement signal and to form local digital measurement values; and
    - the signal conversion device (26) of the digital measurement input (20) is designed to use the sampling rate and/or the sampling times of the local digital measurement values as the specified sampling rate and/or specified sampling times in order to adapt the sampling rate and/or sampling times of the digital input measurement values.

12. Electric automation device (11) according to one of Claims 10 and 11,
    **characterized in that**

    - the automation device (11) has at least one further digital measurement input which is designed according to the digital measurement input (20).

**13.** Electric automation device (11) according to one of Claims 10 and 11,
**characterized in that**

- the digital measurement input (20) is designed to receive and process a plurality of sequences of digital input measurement values.

**14.** Method for processing digital input measurement values which have been generated by sampling an analog measurement signal at a first sampling rate, wherein, in the method:

- the digital input measurement values are received with a receiving device (21) of a digital measurement input (20) of an automation device (11); and
- digital output measurement values are formed and provided with a signal conversion device (26) of the digital measurement input (20) from the digital input measurement values, wherein the sampling rate and/or respective sampling times of the digital output measurement values are adapted to a specified sampling rate and/or specified sampling times, wherein
- the digital input measurement values are filtered with a digital encoder filter (23) of the signal conversion device (26) with formation of encoded digital input measurement values,
- the encoded digital input measurement values are interpolated with an interpolator (24) of the signal conversion device (26) with formation of digital auxiliary measurement values; and
- the digital auxiliary measurement values are filtered with a digital decoder filter (25) of the signal conversion device (26) with formation of the digital output measurement values; **characterized in that**
- the encoder filter (23), the interpolator (24) and the decoder filter (25) are matched to one another so that they effect the adaptation of the sampling rate and/or sampling times of the digital input measurement values.

**15.** Method according to Claim 14,
**characterized in that**

- a common transmission function resulting from a linking of the individual transmission functions of the encoder filter (23) and the decoder filter (25) effects an adjustable shift of the phase response of the sequence of digital input measurement values in order to generate a required temporal shift of the digital output measurement values compared with the digital input measurement values.

**Revendications**

**1.** Entrée (20) de mesure numérique d'un appareil (11) électrique d'automatisation, comprenant

- un dispositif (21) de réception, conçu pour recevoir des valeurs de mesure d'entrée numériques, qui ont été produites par échantillonnage d'un signal de mesure analogique à un premier taux d'échantillonnage, et
- un dispositif (26) de transformation du signal, constitué pour former et mettre à disposition des valeurs de mesure de sortie numériques à partir des valeurs de mesure d'entrée numériques, les valeurs de mesure de sortie numériques étant adaptées, en ce qui concerne leur taux d'échantillonnage et/ou leur instant respectif d'échantillonnage, à un taux d'échantillonnage donné à l'avance et/ou à des instants d'échantillonnage donnés à l'avance, dans lequel
- le dispositif (26) de transformation de signal a, du côté de l'entrée, un filtre (23) codeur numérique et, du côté de la sortie, un filtre (25) décodeur numérique entre lesquels est prévu un interpolateur (24), **caractérisée en ce que**
- le filtre (23) codeur, l'interpolateur (24) et le filtre (25) décodeur sont accordés les uns aux autres, de manière à provoquer par eux l'adaptation des valeurs de mesure d'entrée numériques en ce qui concerne le taux d'échantillonnage et/ou les instants d'échantillonnage.

**2.** Entrée (20) de mesure numérique suivant la revendication 1,
**caractérisée en ce que**

- l'interpolateur (24) est conçu pour la production de valeurs de mesure auxiliaires numériques interpolées, en utilisant un modèle de signal.

**3.** Entrée (20) de mesure numérique suivant la revendication 2,

**caractérisée en ce que**

- le modèle de signal décrit une fonction quadratique.

**4.** Entrée (20) de mesure numérique suivant l'une des revendications précédentes,
**caractérisée en ce que**

- le filtre (23) codeur et le filtre (25) décodeur ont des fonctions de transfert individuelles, qui peuvent être accordées l'une à l'autre, de manière à ce que leur fonction de transfert commune provoque un décalage réglable de la réponse de phase de la séquence de valeurs de mesure d'entrée numériques pour produire un décalage dans le temps souhaité des valeurs de mesure de sortie numériques par rapport aux valeurs de mesure d'entrée numériques.

**5.** Entrée (20) de mesure numérique suivant l'une des revendications précédentes,
**caractérisée en ce que**

- le filtre (23) codeur a une caractéristique PD et le filtre (25) décodeur a une caractéristique passe-bas.

**6.** Entrée (20) de mesure numérique suivant l'une des revendications précédentes,
**caractérisée en ce que**

- l'entrée (20) de mesure numérique est constituée sous la forme d'un module de traitement à programmation définie en matériel, notamment d'un ASIC ou d'un FPVA.

**7.** Entrée (20) de mesure numérique suivant la revendication 6,
**caractérisée en ce que**

- le module de traitement a un registre de mémoire, dans lequel peuvent être mis en mémoire, de manière variable, des coefficients de filtre du filtre codeur et/ou du filtre décodeur.

**8.** Entrée (20) de mesure numérique suivant l'une des revendications précédentes,
**caractérisée en ce que**

- le dispositif (21) de réception est constitué pour la réception des valeurs de mesure d'entrée numériques, sous la forme de télégrammes de données.

**9.** Entrée (20) de mesure numérique suivant la revendication 8,
**caractérisée en ce que**

- le dispositif (21) de réception est conçu pour prélever, des télégrammes de données contenant les valeurs de mesure d'entrée numériques, une information sur le premier taux d'échantillonnage et la transmettre au dispositif (26) de transformation du signal.

**10.** Appareil (11) électrique d'automatisation, ayant une entrée (20) de mesure numérique suivant l'une des revendications 1 à 9 précédentes.

**11.** Appareil (11) électrique d'automatisation suivant la revendication 10,
**caractérisé en ce que**

- l'appareil (11) électrique d'automatisation a au moins une entrée de signal analogique, conçue pour la détection d'un signal de mesure analogique local et pour la formation de valeurs de mesure numériques locales et
- le dispositif (26) de transformation de signal de l'entrée (20) de mesure numérique est constitué de manière à utiliser, pour l'adaptation des valeurs de mesure d'entrée numériques en ce qui concerne le taux d'échantillonnage et/ou les instants d'échantillonnage, le taux d'échantillonnage et/ou les instants d'échantillonnage des valeurs de mesure numériques locales, comme taux d'échantillonnage donné à l'avance et/ou instants d'échantillonnage donnés à l'avance.

**12.** Appareil (11) électrique d'automatisation suivant l'une des revendications 10 ou 11,

**caractérisé en ce que**

    - l'appareil (11) d'automatisation a au moins une autre entrée de mesure numérique, qui sont constituées conformément à l'entrée (20) de mesure numérique.

**13.** Appareil (11) électrique d'automatisation suivant l'une de revendications 10 ou 11, **caractérisé en ce que**

    - l'entrée (20) de mesure numérique est constituée pour la réception et le traitement de plusieurs courbes de valeurs de mesure d'entrée numériques.

**14.** Procédé de traitement de valeurs de mesure d'entrée numériques, qui ont été produites par échantillonnage d'un signal de mesure analogique à un premier taux d'échantillonnage, procédé dans lequel

    - par un dispositif (21) de réception d'une entrée (20) de mesure numérique d'un appareil (11) d'automatisation, on reçoit les valeurs de mesure d'entrée numériques et
    - par un dispositif (26) de transformation du signal de l'entrée (20) de mesure numérique, on forme et on met à disposition les valeurs de mesure de sortie numériques à partir des valeurs de mesure d'entrée numériques, les valeurs de mesure de sortie numériques étant adaptées en ce qui concerne leur taux de balayage et/ou leur instant d'échantillonnage respectif à un taux d'échantillonnage donné à l'avance et/ou à des instants d'échantillonnage donnés à l'avance, dans lequel
    - on filtre les valeurs de mesure d'entrée numériques par un filtre (23) codeur numérique du dispositif (26) de transformation du signal avec formation de valeurs de mesure d'entrée numériques codées,
    - on interpole les valeurs de mesure d'entrée numériques codées par un interpolateur (24) du dispositif (26) de transformation du signal avec formation de valeurs de mesure auxiliaires numériques et
    - on filtre des valeurs de mesure auxiliaires numériques par un filtre (25) décodeur numérique du dispositif (26) de transformation du signal avec formation des valeurs de mesure de sortie numériques,
    **caractérisé en ce que**
    - le filtre (23) codeur, l'interpolateur (24) et le filtre (25) décodeur sont accordés les uns aux autres, de manière à provoquer l'adaptation des valeurs de mesure d'entrée numériques en ce qui concerne le taux d'échantillonnage et/ou les instants d'échantillonnage.

**15.** Procédé suivant la revendication 14, **caractérisé en ce que**

    - une fonction de transfert commune, provenant d'une combinaison des fonctions de transfert individuelles du filtre (23) codeur et du filtre (25) décodeur, provoque un décalage réglable de la réponse de phase de la séquence des valeurs de mesure d'entrée numériques, pour produire un décalage souhaité dans le temps des valeurs de mesure de sortie numériques par rapport aux valeurs de mesure d'entrée numériques.

FIG 1

# FIG 2

EP 3 072 017 B1

FIG 3

FIG 4

# FIG 5

EP 3 072 017 B1

## FIG 6

**EP 3 072 017 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2503668 A1

- DE 19860720 A1